# EUROPEAN PATENT APPLICATION

(11) **EP 4 745 594 A1**
(43) Date of publication of application: **20.05.2026**
(21) Application number: 25215278.0
(22) Date of filing: 12.11.2025
(51) Int. Cl.: G01R 31/367, G01R 31/392

(54) **SYSTEM AND METHOD FOR PREDICTING DEGRADATION MODE OF BATTERY**

(30) Priority: 15.11.2024 KR 20240163285
(71) Applicant: SAMSUNG SDI CO., LTD., Yongin-si, Gyeonggi-do 17084 (KR)
(72) Inventor: LEE, Yujin, 17084 Yongin-Si (KR); LEE, Dongryul, 17084 Yongin-Si (KR); KWON, Youngwoong, 17084 Yongin-Si (KR); KIM, Haemin, 17084 Yongin-Si (KR); JANG, Junho, 17084 Yongin-si (KR); KO, Younghoon, 17084 Yongin-si (KR); YI, Sangkoan, 17084 Yongin-si (KR)
(74) Representative: Maiwald GmbH

(57) **Abstract**

A battery degradation mode prediction system includes a learning data generation unit for generating learning data including a voltage profile data set for reference batteries and a profile data set for each degradation mode of the reference batteries, a prediction model generation unit for generating a prediction model, a data collection unit for obtaining voltage profile data for a target battery, and a degradation mode analysis unit for obtaining, from the voltage profile data by using the prediction model, profile data for each degradation mode of the target battery, and output lifespan data related to a degradation degree of the target battery for each degradation mode based on the profile data for each degradation mode. The profile data for each degradation mode includes cycle-by-cycle degradation trend information for a degradation parameter associated with an electrode plate or a degradation parameter associated with a resistance of the target battery.

## Description

### BACKGROUND

### 1. FIELD

Aspects of embodiments of the present disclosure relate to a battery degradation mode prediction system and method.

### 2. DESCRIPTION OF THE RELATED ART

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

A secondary battery may experience a degradation phenomenon in which a performance deteriorates as usage time increases. The degradation phenomenon of a secondary battery may occur for various reasons. For example, repeated charge-discharge cycles, excessive current, use at high temperatures, decomposition of an electrolyte, or deterioration of an active material may act as some main factors accelerating the degradation phenomenon.

The above information disclosed in this Background section is for enhancement of understanding of the background of the present disclosure, and therefore, it may contain information that does not constitute related (or prior) art.

### SUMMARY

A degradation phenomenon may cause a reduction in a capacity, a decrease in an output, or an increase in an internal resistance of the secondary battery, and even with a long-term use, may greatly shorten the lifespan of the battery. Therefore, it may be desirable to accurately identify and appropriately manage these degradation modes in order to maintain a performance and extend a lifespan of the secondary battery.

Embodiments of the present disclosure may be directed to a battery degradation mode prediction system and method.

These and other aspects and features of the present disclosure will be described in or will be apparent from the following description of embodiments of the present disclosure.

According to an aspect of the present disclosure, a battery degradation mode prediction system includes: a learning data generation unit configured to generate learning data including a voltage profile data set for a plurality of reference batteries, and a profile data set for each degradation mode of the plurality of reference batteries; a prediction model generation unit configured to generate, based on the learning data, a prediction model trained to receive the voltage profile data set as an input and output the profile data set for each degradation mode corresponding to the voltage profile data set; a data collection unit configured to obtain voltage profile data for a target battery; and a degradation mode analysis unit configured to obtain, from the voltage profile data by using the prediction model, profile data for each degradation mode of the target battery, and output lifespan data related to a degradation degree of the target battery for each degradation mode based on the profile data for each degradation mode. The profile data for each degradation mode includes cycle-by-cycle degradation trend information for at least one of a degradation parameter associated with an electrode plate of the target battery or a degradation parameter associated with a resistance of the target battery.

In an embodiment, the voltage profile data set may include full-cell voltage profile data for the plurality of reference batteries, generated, through an electrochemical model, based on BOL (Begin of Life) data and half-cell data associated with the plurality of reference batteries.

In an embodiment, the half-cell data may include cathode half-cell data and anode half-cell data, and the full-cell voltage profile data may be generated based on resistance characteristics extracted from each of the cathode half-cell data and the anode half-cell data.

In an embodiment, the resistance characteristics may include at least one of a material resistance, an electrode plate resistance, or a diffusion resistance.

In an embodiment, the data collection unit may be configured to measure a voltage value of the target battery and a charge-discharge capacity of the target battery at sampling intervals, and obtain the voltage profile data including a correlation between the voltage value and the charge-discharge capacity.

In an embodiment, the profile data for each degradation mode may include information on at least one of a cycle-by-cycle cathode active material degradation, an anode active material degradation, a lithium plating amount, or a side reaction resistance increase amount for the target battery, estimated through the prediction model.

In an embodiment, the lifespan data may include a degradation rate for each degradation mode of the target battery at a specific cycle.

In an embodiment, the degradation rate may be a percentage representation of a degradation degree estimation value relative to a reference value for each degradation mode of the target battery.

In an embodiment, the degradation mode analysis unit may be configured to compare a degradation degree estimation value for each degradation mode of the target battery with a threshold value, based on the profile data for each degradation mode of the target battery, and visually output the degradation degree estimation value according to a comparison result between the degradation degree estimation value and the threshold value.

In an embodiment, the degradation mode analysis unit may be configured to identify, as a main degradation mode, a degradation mode for which a degradation degree estimation value exceeds a threshold value among a plurality of degradation modes of the target battery, based on the profile data for each degradation mode of the target battery, and output the main degradation mode.

In an embodiment, the prediction model may include: an input layer configured to receive, as input data, the voltage profile data for the target battery; an intermediate layer configured to generate, based on the input data, the profile data for each degradation mode of the target battery as prediction data; and an output layer configured to output the prediction data.

In an embodiment, the intermediate layer may include at least one of: a first intermediate layer configured to extract a feature related to the voltage profile data; a second intermediate layer configured to process continuous time-series characteristics of the voltage profile data; a third intermediate layer configured to select information based on a weight associated with a correlation between the voltage profile data and the profile data for each degradation mode; or a fourth intermediate layer configured to transform a data dimension based on information about a number of degradation modes.

In an embodiment, the second intermediate layer may be configured to obtain an output of the first intermediate layer as an input to the second intermediate layer.

According to an aspect of the present disclosure, a battery degradation mode prediction method includes: generating learning data including a voltage profile data set for a plurality of reference batteries and a profile data set for each degradation mode of the plurality of reference batteries; generating, based on the learning data, a prediction model trained to receive the voltage profile data set as an input and output the profile data set for each degradation mode corresponding to the voltage profile data set; obtaining voltage profile data for a target battery; obtaining, from the voltage profile data by using the prediction model, profile data for each degradation mode of the target battery; and outputting lifespan data related to a degradation degree of the target battery for each degradation mode based on the profile data for each degradation mode. The profile data for each degradation mode includes cycle-by-cycle degradation trend information for at least one of a degradation parameter associated with an electrode plate of the target battery or a degradation parameter associated with a resistance of the target battery.

In an embodiment, the voltage profile data set may include full-cell voltage profile data for the plurality of reference batteries, generated, through an electrochemical model, based on BOL (Begin of Life) data and half-cell data associated with the plurality of reference batteries.

In an embodiment, the half-cell data may include cathode half-cell data and anode half-cell data, and the full-cell voltage profile data may be generated based on resistance characteristics extracted from each of the cathode half-cell data and the anode half-cell data.

In an embodiment, the obtaining of the voltage profile data for the target battery may include: measuring a voltage value of the target battery and a charge-discharge capacity of the target battery at sampling intervals; and obtaining the voltage profile data including a correlation between the voltage value and the charge-discharge capacity.

In an embodiment, the profile data for each degradation mode may include information on at least one of a cycle-by-cycle cathode active material degradation, an anode active material degradation, a lithium plating amount, or a side reaction resistance increase amount for the target battery, estimated through the prediction model.

In an embodiment, the lifespan data may include a degradation rate for each degradation mode of the target battery at a specific cycle.

In an embodiment, a non-transitory computer-readable recording medium may store a program that, when executed by a processor, causes the processor to perform the method.

According to some embodiments of the present disclosure, a battery internal degradation state may be analyzed or inferred via a battery degradation mode prediction model. As such, the degradation state may be easily identified without a complicated process, such as a battery disassembly, and a degradation trend may be quickly and simply confirmed. In addition, an accuracy of a battery lifespan prediction may be improved through an automated prediction model.

According to some embodiments of the present disclosure, a variety of degradation factors of a battery may be comprehensively considered, enabling the internal degradation state of the battery to be more precisely predicted. Furthermore, a capacity reduction according to each degradation mode may be easily reflected ex post facto, and thus, after sales service management of the battery may be performed more efficiently.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 illustrates an example of a battery degradation mode prediction system according to an embodiment of the present disclosure.
FIG. 2 is a block diagram illustrating the battery degradation mode prediction system of FIG. 1.
FIG. 3 is a block diagram illustrating an information processing system used for a battery degradation mode prediction according to an embodiment of the present disclosure.
FIG. 4 is a diagram illustrating an example of a method of generating learning data in a battery degradation mode prediction system according to an embodiment of the present disclosure.
FIG. 5 is a diagram illustrating an example of a method of generating a prediction model in a battery degradation mode prediction system according to an embodiment of the present disclosure.
FIG. 6 is a diagram illustrating an example of a method of predicting a degradation mode for a target battery in a battery degradation mode prediction system according to an embodiment of the present disclosure.
FIG. 7 illustrates an example of an artificial neural network model for predicting a battery degradation mode according to an embodiment of the present disclosure.
FIG. 8 is a diagram illustrating an example of a prediction model of a battery degradation mode prediction system according to an embodiment of the present disclosure.
FIG. 9 is a diagram illustrating examples of graphs in which profile data for each degradation mode of a target battery is visually output according to an embodiment of the present disclosure.
FIG. 10 is a diagram illustrating an example of a table in which lifespan data related to a degradation degree of a target battery for each degradation mode is visually shown according to an embodiment of the present disclosure.
FIG. 11 is a flowchart illustrating a battery degradation mode prediction method according to an embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value greater than or equal to 1.0 and a maximum value less than or equal to 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components.

Throughout the specification, when "A and/or B" is stated, it means A, B, or A and B, unless otherwise stated. That is, "and/or" includes any or all combinations of a plurality of items enumerated. When "C to D" is stated, it means greater than or equal to C and less than or equal to D, unless otherwise specified.

As used herein, a reference battery (or a secondary battery) may refer to a battery that may generate data used to train a degradation mode prediction model.

As used herein, a target battery may refer to a battery that is a subject of predicting a degradation mode, a degradation factor, a degradation rate, or a lifespan through the degradation mode prediction model.

As used herein, each of the reference battery and the target battery may include at least one battery cell, and may be a rechargeable secondary battery. For example, each of the reference battery and the target battery may include a lithium-ion battery.

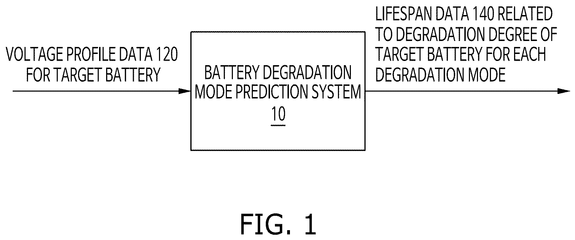

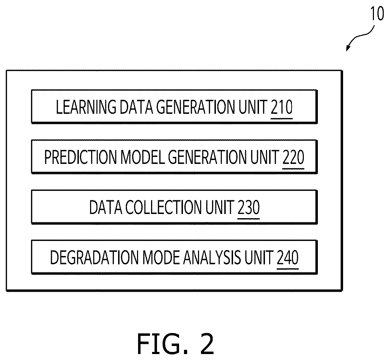

FIG. 1 illustrates an example of a battery degradation mode prediction system 10 according to an embodiment of the present disclosure. FIG. 2 is a block diagram illustrating the battery degradation mode prediction system 10 of FIG. 1.

In an embodiment, the battery degradation mode prediction system 10 may include a learning data generation unit 210, a prediction model generation unit 220, a data collection unit 230, and a degradation mode analysis unit 240. The battery degradation mode prediction system 10 may receive voltage profile data 120 for a target battery as an input, and may output lifespan data 140 related to (e.g., associated with) a degradation degree of the target battery for each degradation mode.

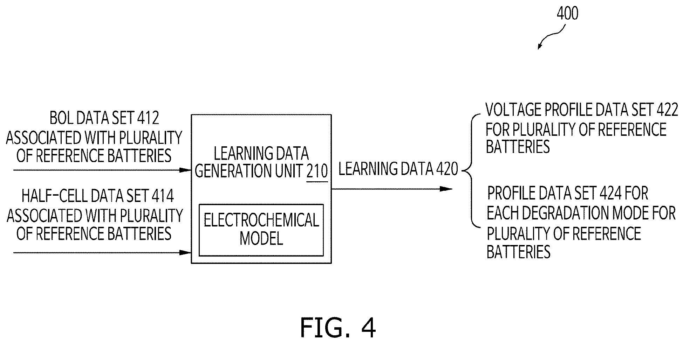

In an embodiment, the learning data generation unit 210 may generate learning data used for training a battery degradation mode prediction model or a prediction model. The learning data may include a voltage profile data set for a plurality of reference batteries, and a profile data set, for each degradation mode, for the plurality of reference batteries. Further, the learning data generation unit 210 may generate the learning data by using an electrochemical model. The learning data generation unit 210 for generating the learning data will be described in more detail below with reference to FIG. 4.

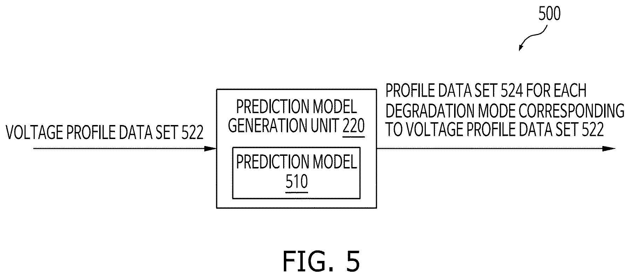

In an embodiment, the prediction model generation unit 220 may generate a prediction model. The prediction model generation unit 220 may acquire the learning data from the learning data generation unit 210. The prediction model may be trained to identify correlations among the learning data. In other words, the prediction model may be trained to receive, as an input, the voltage profile data set for the plurality of reference batteries, and may output the profile data set for each degradation mode corresponding to the input. The prediction model generation unit 220 for generating the prediction model will be described in more detail below with reference to FIG. 5.

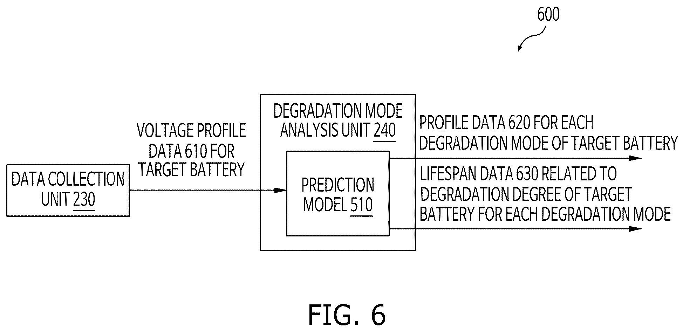

In an embodiment, the data collection unit 230 may acquire measurement data for the target battery that is the subject of an inference. For example, the measurement data for the target battery may include the voltage profile data 120 for the target battery. The data collection unit 230 may directly measure the target battery to obtain real-time data, or may obtain pre-measured data from a battery management system associated with the target battery. The data collection unit 230 for acquiring the measurement data for the target battery will be described in more detail below with reference to FIG. 6.

In an embodiment, the degradation mode analysis unit 240 may acquire profile data for each degradation mode of the target battery. The degradation mode analysis unit 240 may access the prediction model generated by the prediction model generation unit 220. In addition, the degradation mode analysis unit 240 may obtain the measurement data of the target battery from the data collection unit 230. As such, the degradation mode analysis unit 240 may use the prediction model to acquire profile data for each degradation mode of the target battery from the measurement data of the target battery. The profile data for each degradation mode may include cycle-by-cycle degradation trend information for at least one of a degradation parameter associated with an electrode plate of the target battery or a degradation parameter associated with a resistance of the target battery. The degradation mode analysis unit 240 for acquiring the profile data for each degradation mode of the target battery will be described in more detail below with reference to FIG. 6.

In an embodiment, the degradation mode analysis unit 240 may output the lifespan data 140 related to a degradation degree of the target battery for each degradation mode. The degradation mode analysis unit 240, based on the profile data for each degradation mode of the target battery acquired using the prediction model, may output the lifespan data related to the degradation degree of the target battery for each degradation mode. The lifespan data will be described in more detail below with reference to FIG. 6.

Through the above configuration, the battery degradation prediction system 10 may analyze or infer an internal degradation state of a battery through a battery degradation mode prediction model. Accordingly, the degradation state may be more easily identified without a complicated process, such as a battery disassembly, and the degradation trend may be quickly and simply confirmed. Moreover, the accuracy of a battery lifespan prediction may be improved through the automated prediction model.

Furthermore, through the above configuration, a variety of degradation factors of the battery may be comprehensively considered, enabling the internal degradation state of the battery to be more precisely predicted. In addition, reflecting a capacity reduction according to each degradation mode ex post facto may become easier, so that after-service management of the battery may be more efficiently performed.

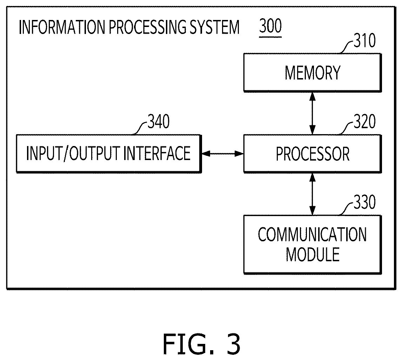

FIG. 3 is a block diagram illustrating an information processing system 300 used for a battery degradation mode prediction according to an embodiment of the present disclosure.

The information processing system 300 may correspond to the battery degradation mode prediction system 10 illustrated in FIGS. 1 and 2. The information processing system 300 may include a memory 310, a processor 320, a communication module 330, and an input/output interface 340. The information processing system 300 may communicate information and/or data through a network by using the communication module 330. The information processing system 300 may be composed of at least one device including the memory 310, the processor 320, the communication module 330, and the input/output interface 340.

The memory 310 may include any suitable non-transitory computer-readable recording medium. According to an embodiment, the memory 310 may include a permanent mass storage device, such as ROM (read-only memory), a disk drive, an SSD (solid state drive), or a flash memory. As another example, a permanent mass storage device, such as ROM, an SSD, a flash memory, or a disk drive, may be included in the information processing system 300 as a separate permanent storage device distinct from the memory 310. In addition, the memory 310 may store software components including an operating system and at least one program code (e.g., code for generating and training a degradation mode prediction model installed and driven in the information processing system 300, and code for predicting the degradation mode of a target battery by using the prediction model).

The software components may be loaded from a separate computer-readable recording medium distinct from the memory 310. A separate computer-readable recording medium may be a recording medium directly connectable to the information processing system 300, for example, such as a floppy drive, a disk, a tape, a DVD/CD-ROM drive, or a memory card. As another example, the software components may be loaded into the memory 310 via the communication module 330, which may not be a computer-readable recording medium. For example, at least one program may be loaded into the memory 310, based on files provided through the communication module 330 either by developers or by a file distribution system that distributes installation files of an application. The program may include, for example, a program for generating and training the degradation mode prediction model, and for predicting the degradation mode of a target battery by using the prediction model.

The processor 320 may process commands of a computer program by performing basic arithmetic, logic, and input/output operations. The commands may be provided by the memory 310 or the communication module 330 from a user terminal or another external system. For example, the processor 320 may receive, from one or more external devices or battery manufacturing facilities, learning data including a voltage profile data set for reference batteries, a profile data set for each degradation mode, and/or voltage profile data for a target battery, as well as data for various kinds of batteries. The processor 320 may generate and train a degradation mode prediction model based on the learning data, or based on the voltage profile data of the target battery, may use the prediction model to calculate the profile data for each degradation mode of the target battery and/or lifespan data related to the degradation degree for each degradation mode.

The communication module 330 may provide a configuration or a function so that the user terminal and the information processing system 300 may communicate with each other through a network, and may provide a configuration or a function so that the information processing system 300 may communicate with an external system (e.g., a separate battery manufacturing process facility, a cloud system, and the like). For example, control signals, commands, data, and the like provided under the control of the processor 320 of the information processing system 300 may be transmitted to the user terminal and/or the external system through the communication module 330 and the network, via the communication module of the user terminal and/or the external system. For example, a lifespan state of the target battery generated by the information processing system 300 may be transmitted to the user terminal and/or the external system through the communication module 330 and the network, via the communication module of the user terminal and/or the external system. In addition, the user terminal and/or the external system that receives the lifespan state of the target battery may output the received information through a device capable of a display output.

The input/output interface 340 of the information processing system 300 may be a means for interfacing with a device for input or output, which may be connected to or included in the information processing system 300. In FIG. 3, the input/output interface 340 is illustrated as a component separate from the processor 320, but the present disclosure is not limited thereto. The input/output interface 340 may be included in the processor 320. The information processing system 300 may include more components than those shown in FIG. 3.

The processor 320 of the information processing system 300 may manage, process, and/or store information and/or data received from a plurality of user terminals and/or a plurality of external systems. According to an embodiment, the processor 320 may receive, from the user terminal and/or the external system, learning data associated with reference batteries, and/or voltage profile data of a target battery, and lifespan data of various kinds of batteries. The processor 320 may calculate profile data segmented by each degradation mode of the target battery and/or lifespan data based on the target battery's voltage profile data using the degradation mode prediction model, and may output the calculated lifespan data and the like through a device capable of a display output that is connected to the information processing system 300.

FIG. 4 is a diagram illustrating an example of a method 400 of generating learning data 410 in the battery degradation mode prediction system according to an embodiment of the present disclosure. Hereinafter, with reference to FIG. 4, redundant description as those described above with reference to FIGS. 1 to 3 may not be repeated.

In an embodiment, the learning data generation unit 210 may generate learning data 420. The learning data 420 may include a voltage profile data set 422 for a plurality of reference batteries and/or a profile data set 424 for each degradation mode for the plurality of reference batteries. The learning data 420 may be provided to the prediction model generation unit 220 as basic data used for training the battery degradation mode prediction model.

In an embodiment, the voltage profile data set 422 may include data, such as a voltage and a capacity measured over a number of lifespan cycles (e.g., a predetermined number of lifespan cycles) for each of the plurality of reference batteries. The reference batteries may be full cells, from BOL (Begin of Life) to EOL (End of Life), where data is collected over multiple lifespan cycles. For example, data may be measured in 100-cycle increments over 1,000 lifespan cycles.

In an embodiment, the profile data set 424 for each degradation mode may include cycle-by-cycle voltage and capacity change information (e.g., predetermined cycle-by-cycle voltage and capacity change information) according to a degradation mode (or degradation factor). The degradation mode may refer to a physicochemical change or a degradation mechanism of an internal configuration that affects a battery performance. For example, a cathode active material, an anode active material, a lithium plating amount on the anode, and an increase amount for side reaction resistance may be included.

In an embodiment, the learning data generation unit 210 may generate the learning data 420 based on a BOL data set 412 and a half-cell data set 414 associated with a plurality of reference batteries. The BOL data set 412 may include electrochemical characteristics, such as a voltage, a charge capacity, or an internal resistance of the reference batteries in an initial manufactured state, which are full cells. This enables the initial performance of the reference batteries to be used as a baseline for tracking the internal degradation process, forming basic data for the prediction model. The half-cell data set 414 may include cathode half-cell data and anode half-cell data, as well as independent analysis data for each of the cathode and the anode. As such, the material, specifications, an arrangement structure, and changes in electrode plates, active materials, and the like of each electrode may be reflected, thereby clearly identifying electrochemical changes and performance degradation that may occur in each electrode. Because both the BOL data set 412 and the half-cell data set 414 for the full cells are considered together in generating the learning data, the battery degradation mechanism may be more precisely analyzed and predicted.

In an embodiment, the learning data generation unit 210 may generate the learning data 420 through an electrochemical model. For example, various resistance characteristics of half-cells may be separately extracted through the electrochemical model, and based on the resistance characteristics, a full-cell voltage profile may be generated. Accordingly, the electrochemical interactions inside the battery may be modeled, and the battery degradation process may be more precisely analyzed and predicted.

In an embodiment, the resistance characteristics may include at least one of a material resistance, an electrode plate resistance, or a diffusion resistance extracted from each of the cathode and anode half-cells. The full-cell voltage profile data of the plurality of reference batteries may be generated based on the extracted resistance characteristics. The material resistance may include a resistance related to an electrical conductivity of cathode and anode active materials. The electrode plate resistance may be associated with electrochemical reactions occurring on the electrode surface, and may be a basis for analyzing a charge-discharge efficiency. The diffusion resistance may include a resistance associated with the migration speed of lithium ions.

FIG. 5 is a diagram illustrating an example of a method 500 of generating a prediction model 510 in the battery degradation mode prediction system according to an embodiment of the present disclosure.

In an embodiment, the prediction model generation unit 220 may train and generate the prediction model 510, such that, upon receiving a voltage profile data set 522 for the plurality of reference batteries as an input, a profile data set 524 for each degradation mode corresponding to the voltage profile data set 522 is output. The voltage profile data set 522 and the profile data set 524 for each degradation mode may correspond to the voltage profile data set 422 and the profile data set 424 for each degradation mode included in the learning data 420 generated by the learning data generation unit 210 of FIG. 4. Hereinafter, with reference to FIG. 5, redundant description as those above with reference to FIGS. 1 to 4 may not be repeated.

In an embodiment, the prediction model generation unit 220 may train a correlation between the voltage profile data set 522 over a number of lifespan cycles (e.g., a predetermined number of lifespan cycles) of the reference batteries and the profile data set 524 for each degradation mode corresponding thereto. The prediction model 510 may learn the degradation trends of the reference batteries by each degradation mode, so as to be capable of predicting the internal degradation state of a target battery.

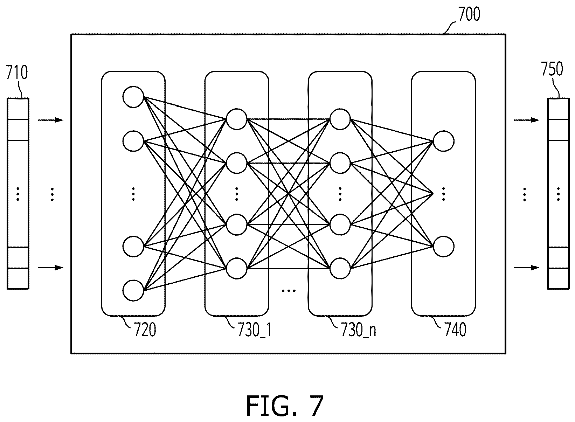

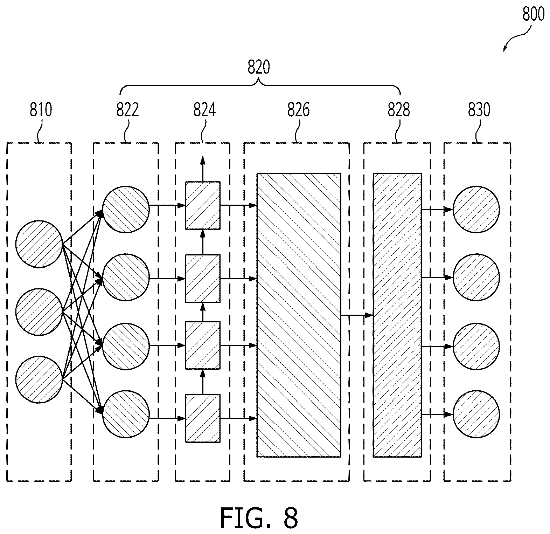

In an embodiment, the prediction model 510 may include a machine learning model based on LSTM (Long Short-Term Memory) that may be optimized or improved for processing time-series data. As such, continuous voltage change patterns included in the voltage profile data and the correlation with the profile data for each degradation mode may be more effectively analyzed. Further, an optimization algorithm (e.g., a Bayesian Optimizer) may be utilized to optimize parameters and a structure of the model, thereby maximizing or increasing the performance of the prediction model 510. However, the prediction model 510 is not limited to LSTM, and a more detailed description of the prediction model 510 will be provided below with reference to FIGS. 7 and 8.

FIG. 6 is a diagram illustrating an example of a method 600 of predicting a degradation mode for a target battery in the battery degradation mode prediction system according to an embodiment of the present disclosure. Hereinafter with reference to FIG. 6, redundant description as those above with reference to FIGS. 1 to 5 may not be repeated.

In an embodiment, the data collection unit 230 may obtain voltage profile data 610 for the target battery. The data collection unit 230 may, at suitable sample intervals (e.g., at predetermined sampling intervals), directly measure a voltage value and a charge-discharge capacity of the target battery to acquire the voltage profile data 610 including a correlation between the measured voltage value and the charge-discharge capacity. However, the method of obtaining the voltage profile data 610 is not limited thereto. For example, the data collection unit 230 may collect voltage and charge-discharge data of the target battery from a battery management system or an external measurement device associated with the target battery, via a communication module (e.g., 330 in FIG. 3). In addition, the data collection unit 230 may acquire data of the target battery through a cloud-based measurement system.

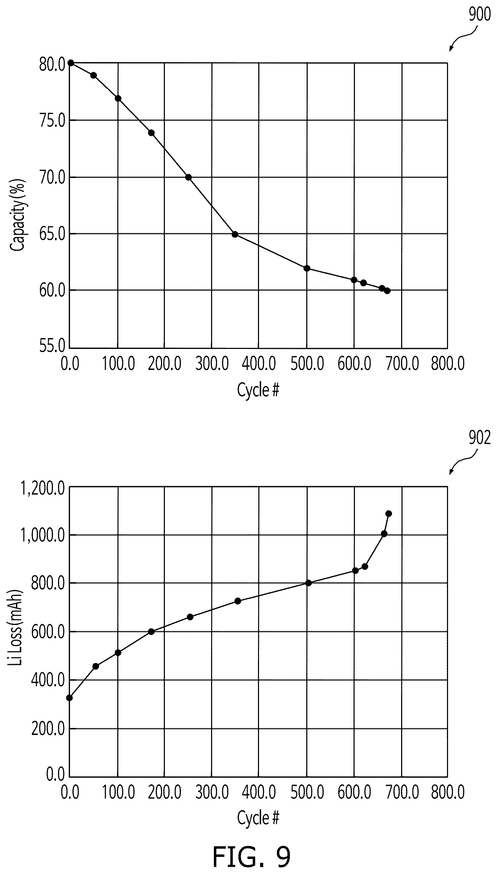

In an embodiment, the degradation mode analysis unit 240 may use the prediction model 510 to predict profile data 620 for each degradation mode of the target battery, by receiving the voltage profile data 610 of the target battery as an input. The degradation modes may include major factors affecting the degradation of the target battery, such as various degradation parameters associated with an electrode plate or a resistance of the battery. For example, the degradation modes may include a cathode active material degradation amount, an anode active material degradation amount, a lithium plating amount, or a side reaction resistance increase amount for the target battery. In addition, the profile data 620 for each degradation mode may include information reflecting the cycle-by-cycle degradation trend of the target battery according to the degradation mode. For example, data may be included that shows a rate of degradation of the cathode and anode active materials per usage cycle of the battery, a reduction in capacity caused by lithium plating, or a pattern of increasing an internal resistance due to side reactions over time. An example of visually outputting the profile data 620 for each degradation mode is described in more detail below with reference to FIG. 9.

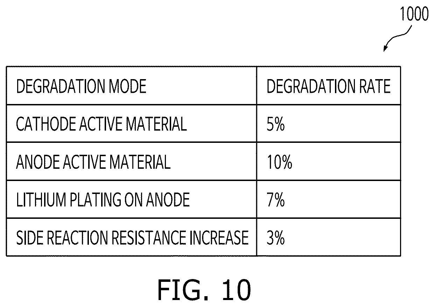

In an embodiment, the degradation mode analysis unit 240 may output lifespan data 630 related to the degradation degree of the target battery for each degradation mode, based on the voltage profile data 610 and/or the profile data 620 for each degradation mode, using the prediction model 510. The lifespan data 630 may include information for quantitatively evaluating the degradation state of the target battery, and predicting a remaining lifespan. An example of visually outputting the lifespan data 630 is described in more detail below with reference to FIG. 10.

In an embodiment, in relation to the degradation degree or the lifespan data of the target battery according to the degradation mode, a degradation reference value and a threshold value for the target battery may be defined. The degradation threshold value and/or the reference value for each degradation mode of the target battery may be derived in a process of training the prediction model 510 with learning data based on a plurality of reference batteries. As another example, the degradation reference value and the threshold value may be determined (e.g., predetermined) or obtained by a user input.

The reference value may be a value for the normal operating range of the battery, representing a permissible level of degradation at which the battery may operate safely and stably under a general degradation condition. A degradation degree within the reference value may be considered not to significantly affect a battery performance, and if (e.g., when) the estimated degradation degree of the target battery is included in such a range, it may be predicted that the battery may still operate stably.

On the other hand, the threshold value may be defined as a limit point that may critically affect a battery performance or a lifespan. If (e.g., when), in a certain degradation mode, the degradation degree exceeds the threshold value, it may mean that the battery performance begins to deteriorate rapidly, or that there is a possibility of a safety issue arising. For example, if (e.g., when) it is determined that the degradation degree of the cathode active material estimated through the prediction model exceeds the threshold value, it may be predicted that immediate after-service management for the cathode active material may be desired for the performance or safety of the target battery.

In an embodiment, the lifespan data 630 may include the degradation rate of the target battery for each degradation mode, which may be estimated by the prediction model 510 at a specific cycle. The degradation rate may include a value obtained by expressing, as a percentage, the estimated degradation degree compared to a reference value for the battery performance in each degradation mode. Through the degradation rate, the progress of degradation of the target battery may be more precisely estimated.

In an embodiment, the degradation mode analysis unit 240 may compare the degradation degree estimation value for each degradation mode of the target battery with the threshold value, based on the profile data 620 for each degradation mode of the target battery, and may visually output the estimation value according to a comparison result between the estimation value and the threshold value. For example, if (e.g., when) it is determined that the degradation estimation value for a certain degradation mode of the target battery is close to or exceeds the threshold value, the estimation value may be output in a visually emphasized manner. A visual dashboard or a graph may intuitively convey the estimated degradation state of the target battery to a user, and a degradation mode exceeding the threshold value may be displayed in a warning color (e.g., red), indicating that immediate management may be desired.

In an embodiment, the degradation mode analysis unit 240 may identify, as a main degradation mode, the degradation mode for which the degradation degree estimation value exceeds the threshold value, based on the profile data 620 for each degradation mode, and may output the main degradation mode. For example, the main degradation modes may be displayed in order of the largest amount by which the degradation degree estimation value exceeds the threshold value. In this case, the main degradation modes may be displayed in a profile graph or a table, which may be differentiated by color depending on the degree in which the threshold value is exceeded. For example, a degradation mode for which the degradation degree estimation value exceeds the threshold value by more than a suitable numeric range (e.g., a predetermined numeric range) may be displayed in red, a medium range in yellow, and a minor range in green, in a graph or a table.

As such, the user may intuitively grasp the severity of the degradation state of the target battery for each degradation mode, and may more easily identify the degradation modes that require urgent management.

FIG. 7 illustrates an example of an artificial neural network model 700 for predicting a battery degradation mode according to an embodiment of the present disclosure.

The artificial neural network model 700 may refer to a statistical learning algorithm or an execution structure of the algorithm that is implemented based on biological neural network structures in a machine learning (Machine Learning) technology and cognitive science. The artificial neural network model 700 may correspond to the prediction model 510 of FIG. 5.

In an embodiment, the artificial neural network model 700 may be a machine learning model in which nodes (e.g., artificial neurons) that form a network via synaptic connections adjust synaptic weights repeatedly, so that an error between a correct output corresponding to a specific input and an inferred output may be reduced, thus having a problem-solving ability. For example, the artificial neural network model 700 may include any suitable stochastic model, neural network model, and/or the like, used in artificial intelligence learning methods such as machine learning or deep learning.

In an embodiment, the artificial neural network model 700 may be implemented as a multilayer perceptron (MLP) composed of multiple layers of nodes and connections therebetween. For example, the artificial neural network model 700 may be implemented by using one of various suitable artificial neural network model structures that include an MLP.

As shown in FIG. 7, the artificial neural network model 700 may be composed of an input layer 720 that receives input data including voltage profile data 710 for a target battery, an output layer 740 that outputs, as output data corresponding to the input data, profile data 750 for each degradation mode of the target battery, and n hidden layers 730_1 to 730_n (where n is a natural number) that are located between the input layer 720 and the output layer 740, receive signals from the input layer 720, extract features, and deliver the features to the output layer 740. The output layer 740 may receive the signals from the hidden layers 730_1 to 730_n, and may output the signals externally.

In an embodiment, the learning method of the artificial neural network model 700 may include a supervised learning method in which the model is trained to be optimized for problem solving by inputting teacher signals (e.g., correct answers), and an unsupervised learning method that does not use or require teacher signals. As an example, an information processing system may use, as learning data, the voltage profile data set for a plurality of reference batteries and the profile data set for each degradation mode of the plurality of reference batteries, and may use the correspondence between the voltage profile data set and the profile data set for each degradation mode as ground truth data to perform supervised learning to analyze the plurality of reference batteries, and may train the artificial neural network model 700 so that the profile data for each degradation mode of the target battery and/or lifespan data related to the degradation degree of the target battery for each degradation mode, corresponding to the target battery's voltage profile data, may be inferred.

In an embodiment, the information processing system may train the artificial neural network model 700, so that a difference between the profile data set for each degradation mode for a reference battery predicted by the artificial neural network model 700 and the ground truth data is minimized or reduced.

Thus, multiple input variables and multiple output variables corresponding thereto may be respectively matched to the input layer 720 and the output layer 740 of the artificial neural network model 700, and by adjusting synapse values among the nodes included in the input layer 720, the hidden layers 730_1 to 730_n, and the output layer 740, a correct output corresponding to a specific input may be extracted. Through the learning process, the artificial neural network model 700 may identify characteristics hidden in the input variables, and the synapse values (e.g., weights) among the nodes of the artificial neural network model 700 may be adjusted, so that the error between the output variables calculated based on the input variables and the target output is reduced.

Through such a configuration, the battery degradation mode prediction system 10 may appropriately estimate the profile data for each degradation mode of the target battery and/or the lifespan data related to the degradation degree for each degradation mode by using the artificial neural network model 700 trained based on a plurality of reference batteries and based on input data 710 from the profile data of the target battery.

FIG. 8 is a diagram illustrating an example of a prediction model 800 of the battery degradation mode prediction system according to an embodiment of the present disclosure.

The prediction model 800 may include an input layer 810, an intermediate layer 820, and an output layer 830, and may correspond to the artificial neural network model 700 of FIG. 7. Hereinafter with refence to FIG. 8, redundant description as those above with reference to FIGS. 1 to 7 may not be repeated.

In an embodiment, the input layer 810 may receive voltage profile data for a target battery. The input data may include time-series correlation information between the voltage change of the target battery and its charge-discharge capacity. As such, basic data for predicting the internal degradation state of the battery may be provided.

In an embodiment, the output layer 830 may output prediction data generated based on the input data. The prediction data may include profile data for each degradation mode of the target battery. In an embodiment, the prediction data may further include lifespan data according to the degradation degree for each degradation mode of the target battery. As such, information about the internal degradation state and a remaining lifespan of the battery may be effectively provided.

In an embodiment, the intermediate layer 820 may generate prediction data for the target battery based on the input data. The intermediate layer 820 may include one or more detailed intermediate layers. Each of the detailed intermediate layers may perform a specific role. For example, to analyze time-series characteristics of the input data, LSTM (Long Short-Term Memory) or Bi-LSTM (Bidirectional LSTM) may be used as a second intermediate layer 824. As such, the continuous characteristics of the voltage profile data may be effectively analyzed.

In an embodiment, the intermediate layer 820 may include a first intermediate layer 822 so that features and patterns of the input data may be extracted. For example, the process may include extracting information, such as the rate of change of the voltage value of the target battery, variability patterns, outliers, asymmetry, and peak values. To extract the features, the first intermediate layer 822 may include a CNN (Convolutional Neural Network) neural network model that performs convolution operations on the input data.

In an embodiment, the first intermediate layer 822 may be disposed upstream of the second intermediate layer 824. In addition, the output of the first intermediate layer 822 may be transferred as an input to the second intermediate layer 824. As such, prediction reflecting the features and time-series characteristics of the voltage profile data may be possible, and the performance and the accuracy of the prediction model may be improved.

In an embodiment, the intermediate layer 820 may include an attention mechanism as a third intermediate layer 826. The third intermediate layer 826 may analyze correlations between the input data and output data, and may assign a high weight to information having a high mutual correlation. For example, in the learning process, the correlation between the voltage profile data set of the plurality of reference batteries and the profile data set for each degradation mode may be analyzed, and a higher weight may be assigned to the activation associated with the voltage profile data that has a high correlation with the output value. Accordingly, the accuracy of predicting the battery degradation mode or internal degradation tendency of the battery may be improved.

In an embodiment, the intermediate layer 820 may include a fourth intermediate layer (e.g., a Flatten layer) 828 that transforms the dimension of the output data. The fourth intermediate layer 828 may transform the dimension of the output data based on the number of degradation modes. For example, if (e.g., when) the internal degradation state of a battery is analyzed in four degradation modes (such as cathode and anode active material degradation degrees, lithium plating amount, and side reaction resistance increase amount), the fourth intermediate layer 828 may transform the output data according to the number of degradation modes (e.g., four). As such, more precise analysis results may be effectively derived.

Through the above structure, a multi-stage intermediate layer structure may be provided, in which the battery degradation prediction model may comprehensively consider complex characteristics of time-series data and various degradation factors, improving the accuracy and the efficiency of predicting the internal degradation state of the battery.

FIG. 9 is a diagram illustrating examples of graphs 900 and 902 in which profile data for each degradation mode of a target battery is visually output according to an embodiment of the present disclosure.

The graphs 900 and 902 of FIG. 9 may correspond to the profile data 620 for each degradation mode of a target battery, which may be calculated by the degradation mode analysis unit 240 using the prediction model 510 in FIG. 6. Hereinafter, with reference to FIG. 9, redundant description as those above with reference to FIGS. 1 to 8 may not be repeated.

A first graph 900 visually shows how the charge capacity of the anode active material changes with respect to a reference value at each cycle. As such, the degradation trend of the anode active material may be easily confirmed. Furthermore, depending on the progression of the battery degradation over time, the impact of an anode active material degradation on a battery performance may be clearly analyzed.

A second graph 902 numerically shows the increasing pattern of the lithium plating amount estimated as each cycle progresses. As such, how the lithium plating amount increases over time may be visually confirmed, and the effect of lithium plating on a battery degradation may be precisely analyzed.

As described above, the degradation trend of the battery according to each degradation mode may be easily identified, and the battery degradation state may be monitored in real time or the main cause of the battery performance deterioration may be precisely analyzed.

FIG. 10 is a diagram illustrating an example of a table 1000 in which lifespan data related to a degradation degree for each degradation mode of a target battery is visually shown according to an embodiment of the present disclosure.

The table 1000 of FIG. 10 may correspond to the lifespan data 630 related to the degradation degree for each degradation mode of a target battery, which may be calculated by the degradation mode analysis unit 240 using the prediction model 510 in FIG. 6. Hereinafter, with reference to FIG. 10, redundant description as those above with reference to FIGS. 1 to 9 may not be repeated.

The table 1000 visually shows major degradation modes of the target battery and their degradation rates. Each degradation mode may include a cathode active material degradation, an anode active material degradation, a lithium plating on the anode, a side reaction resistance increase, and the like, and the degradation rate for each degradation mode may provide lifespan data related to a performance deterioration of the target battery.

In an embodiment, a plurality of degradation modes may be displayed in order of higher degradation rates. In an embodiment, if (e.g., when) the degradation rate exceeds a threshold value (e.g., a specific or predetermined threshold value), it may be displayed in a visually emphasized manner.

Accordingly, the progress of the battery degradation according to each degradation mode may be easily identified, enabling efficient battery management and performance prediction.

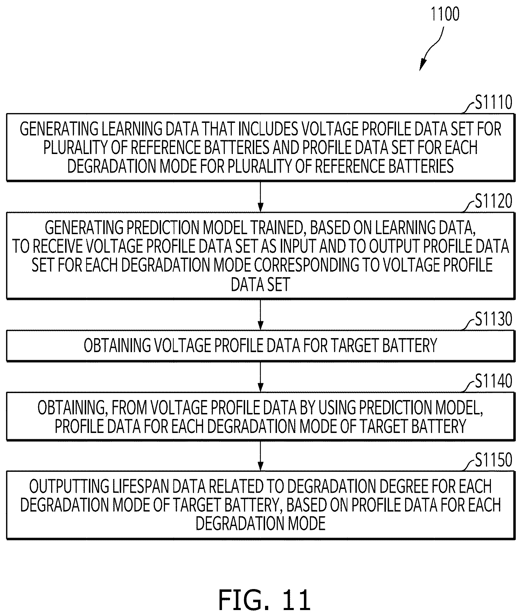

FIG. 11 is a flowchart illustrating a battery degradation mode prediction method 1100 according to an embodiment of the present disclosure.

In an embodiment, the battery degradation mode prediction method 1100 may be performed by at least one processor of a user terminal and/or an information processing system. Hereinafter, with reference to FIG. 11, redundant description as those above with reference to FIGS. 1 to 10 may not be repeated.

In an embodiment, the battery degradation mode prediction method 1100 may begin when a processor generates learning data that includes a voltage profile data set for a plurality of reference batteries and a profile data set for each degradation mode for the plurality of reference batteries (S1110). The voltage profile data set for the plurality of reference batteries may include full-cell voltage profile data for the plurality of reference batteries, which may be generated through an electrochemical model based on BOL (Begin of Life) data and half-cell data associated with the plurality of reference batteries. In addition, the half-cell data may include cathode half-cell data and anode half-cell data, and the full-cell voltage profile data may be generated based on resistance characteristics extracted from each of the cathode half-cell data and the anode half-cell data.

The processor may generate a prediction model that is trained, based on the learning data, to receive the voltage profile data set as an input, and to output the profile data set for each degradation mode corresponding to the voltage profile data set (S1120).

Subsequently, the processor may obtain voltage profile data for a target battery (S1130). The processor may measure the voltage value of the target battery and the charge-discharge capacity of the target battery at suitable sampling intervals (e.g., predetermined sampling intervals), and may obtain the voltage profile data including a correlation between the measured voltage value and the charge-discharge capacity.

The processor may obtain profile data for each degradation mode of the target battery from the voltage profile data by using the prediction model (S1140). The profile data for each degradation mode may include cycle-by-cycle degradation trend information for at least one of a degradation parameter associated with an electrode plate of the target battery or a degradation parameter associated with a resistance of the target battery. For example, the profile data for each degradation mode may include information on at least one of a cycle-by-cycle cathode active material degradation, an anode active material degradation, a lithium plating amount, or a side reaction resistance increase amount for the target battery, which may be estimated by the prediction model.

Then, the processor may output lifespan data related to the degradation degree for each degradation mode of the target battery, based on the profile data for each degradation mode (S1150). The lifespan data may include a degradation rate for each degradation mode of the target battery at a specific cycle.

The above-described method may be provided as a computer program stored in a computer-readable recording medium for execution in a computer. The medium may continuously store a computer-executable program, or may temporarily store it for execution or download. The medium may be a variety of recording or storage means in the form of combined single or multiple hardware, and is not limited to media that is directly connected to a specific computer system. The medium may also exist distributed on a network. Examples of media may include magnetic media, such as a hard disk, a floppy disk, or magnetic tape, optical recording media, such as a CD-ROM or a DVD, magneto-optical media, such as a floptical disk, and ROM, RAM, flash memory, and/or the like, which may store program instructions. Other examples of media may include storage media or recording media managed by an app store that distributes an application or by various other software supply or distribution sites or servers.

The method, operation, technique, and devices (e.g., the learning data generation unit, the prediction model generation unit, the data collection unit, the degradation mode analysis unit, and the like) of the present disclosure may be implemented through various suitable means. For example, they may be implemented via hardware, firmware, software, or a combination thereof. Those having ordinary skill in the art will understand that various logical blocks, modules, circuits, and algorithm processes described in connection with the present disclosure may be implemented in electronic hardware, computer software, or a combination of the two. To more clearly illustrate this mutual substitution of hardware and software, various components, blocks, modules, circuits, and processes have been described generally above in functional terms. Whether such functions are implemented as hardware or software depends on design requirements imposed on a particular application and an overall system. Those having ordinary skill in the art may implement the described functions in diverse ways for each particular application, but such implementations should not be interpreted as being limited according to embodiments of the present disclosure.

In a hardware implementation, processing units used to perform the techniques may be implemented in one or more ASICs, DSPs, digital signal processing devices (DSPDs), programmable logic devices (PLDs), field programmable gate arrays (FPGAs), processors, controllers, microcontrollers, microprocessors, electronic devices, or other electronic units designed to perform the functions described in the present disclosure, computers, or combinations thereof.

Accordingly, various logical blocks, modules, and circuits described in connection with the present disclosure may be implemented or performed using a general-purpose processor, DSP, ASIC, FPGA, or other suitable programmable logic device, discrete gate or transistor logic, discrete hardware components, or any suitable combination thereof designed to perform the functions described in the present disclosure. A general-purpose processor may be a microprocessor, but alternatively, the processor may be any suitable processor, controller, microcontroller, or state machine as would be understood by those having ordinary skill in the art. The processor may also be implemented as a combination of computing devices, for example, a DSP and a microprocessor, multiple microprocessors, one or more microprocessors in conjunction with a DSP core, or any other suitable configuration.

In firmware and/or software implementations, the techniques may be implemented as instructions stored on a computer-readable medium, such as a random access memory (RAM), a read-only memory (ROM), a non-volatile random access memory (NVRAM), a programmable read-only memory (PROM), an erasable programmable read-only memory (EPROM), an electrically erasable PROM (EEPROM), a flash memory, a compact disc (CD), or a magnetic or optical data storage device. The instructions may be executed by one or more processors, causing the processor(s) to perform certain aspects of the functions described herein.

When implemented in software, the techniques may be stored on or transmitted via a computer-readable medium as one or more instructions or code. Computer-readable media include both storage media and communication media, including any suitable medium that facilitates transferring a computer program from one place to another, and encompass any suitable available media accessible by a computer. Storage media may be any suitable usable medium accessible by a computer. Non-limiting examples include RAM, ROM, EEPROM, CD-ROM or other optical disk storage, magnetic disk storage, or any other suitable medium that may be used to carry or store desired program code in the form of instructions or data structures, and which is accessible by a computer. Any connection is properly termed a computer-readable medium as well.

For example, when software is transmitted over a coaxial cable, an optical fiber cable, twisted pair, a digital subscriber line (DSL), or wireless technologies such as infrared, radio, and microwave, from websites, servers, or other remote sources, the coaxial cables, optical fiber cables, twisted pairs, DSL, infrared, radio, and microwave wireless technologies are included within the definition of the medium. The terms disk and disc, as used herein, include compact discs (CDs), laser discs, optical discs, DVDs (digital versatile discs), floppy disks, and Blu-ray discs, where disks normally reproduce data magnetically, while discs reproduce data optically using lasers. Combinations of the above may also be included as computer-readable media.

A software module may reside in a RAM memory, a flash memory, a ROM memory, an EPROM memory, an EEPROM memory, a register, a hard disk, a removable disk, a CD-ROM, or any other suitable form of a storage medium. A storage medium may be coupled to a processor so that the processor can read information from or write information to the storage medium. Alternatively, the storage medium may be integrated into the processor. The processor and the storage medium may reside in an ASIC. The ASIC may reside in a user terminal. Alternatively, the processor and the storage medium may exist as separate components in a user terminal.

Although some embodiments have been described as utilizing one or more standalone computer systems, the present disclosure is not limited thereto, and may be implemented in conjunction with any suitable computing environment, such as a network or distributed computing environment. Further, some embodiments of the present disclosure may be implemented in a plurality of processing chips or devices, and storage may similarly be affected across a plurality of devices. The devices may include PCs, network servers, and portable devices.

### DESCRIPTION OF SOME REFERENCE SYMBOLS

10: battery degradation mode prediction system
120: voltage profile data for target battery
140: lifespan data related to degradation degree of target battery for each degradation mode

## Claims

1. A battery degradation mode prediction system (10) comprising:
a learning data generation unit (210) configured to generate learning data (420) including a voltage profile data set (422) for a plurality of reference batteries, and a profile data set (424) for each degradation mode of the plurality of reference batteries;
a prediction model generation unit (220) configured to generate, based on the learning data (420), a prediction model (510) trained to receive the voltage profile data set (422) as an input and output the profile data set (424) for each degradation mode corresponding to the voltage profile data set (422);
a data collection unit (230) configured to obtain voltage profile data (120, 610) for a target battery; and
a degradation mode analysis unit (240) configured to obtain, from the voltage profile data (120, 610) by using the prediction model (510), profile data (620) for each degradation mode of the target battery, and output lifespan data (140, 630) related to a degradation degree of the target battery for each degradation mode based on the profile data (620) for each degradation mode,
wherein the profile data (620) for each degradation mode comprises cycle-by-cycle degradation trend information for at least one of a degradation parameter associated with an electrode plate of the target battery or a degradation parameter associated with a resistance of the target battery.

2. The battery degradation mode prediction system (10) according to claim 1, wherein the voltage profile data set (422) comprises full-cell voltage profile data for the plurality of reference batteries, generated, through an electrochemical model, based on BOL (Begin of Life) data (412) and half-cell data (414) associated with the plurality of reference batteries.

3. The battery degradation mode prediction system (10) according to claim 2, wherein the half-cell data (414) comprises cathode half-cell data and anode half-cell data, and
wherein the full-cell voltage profile data is generated based on resistance characteristics extracted from each of the cathode half-cell data and the anode half-cell data.

4. The battery degradation mode prediction system (10) according to claim 3, wherein the resistance characteristics comprise at least one of a material resistance, an electrode plate resistance, or a diffusion resistance.

5. The battery degradation mode prediction system (10) according to any one of the preceding claims, wherein the data collection unit (230) is configured to measure a voltage value of the target battery and a charge-discharge capacity of the target battery at sampling intervals, and obtain the voltage profile data (120, 610) including a correlation between the voltage value and the charge-discharge capacity.

6. The battery degradation mode prediction system (10) according to any one of the preceding claims, wherein the profile data (620) for each degradation mode comprises information on at least one of a cycle-by-cycle cathode active material degradation, an anode active material degradation, a lithium plating amount, or a side reaction resistance increase amount for the target battery, estimated through the prediction model (510).

7. The battery degradation mode prediction system (10) according to any one of the preceding claims, wherein the lifespan data (140, 630) comprises a degradation rate for each degradation mode of the target battery at a specific cycle.

8. The battery degradation mode prediction system (10) according to claim 7, wherein the degradation rate is a percentage representation of a degradation degree estimation value relative to a reference value for each degradation mode of the target battery.

9. The battery degradation mode prediction system (10) according to any one of the preceding claims, wherein the degradation mode analysis unit (240) is configured to compare a degradation degree estimation value for each degradation mode of the target battery with a threshold value, based on the profile data (620) for each degradation mode of the target battery, and visually output the degradation degree estimation value according to a comparison result between the degradation degree estimation value and the threshold value.

10. The battery degradation mode prediction system (10) according to any one of the preceding claims, wherein the degradation mode analysis unit (240) is configured to identify, as a main degradation mode, a degradation mode for which a degradation degree estimation value exceeds a threshold value among a plurality of degradation modes of the target battery, based on the profile data (620) for each degradation mode of the target battery, and output the main degradation mode.

11. The battery degradation mode prediction system (10) according to any one of the preceding claims, wherein the prediction model (510) comprises:
an input layer (720, 810) configured to receive, as input data, the voltage profile data (120, 610) for the target battery;
an intermediate layer (820) configured to generate, based on the input data, the profile data (620) for each degradation mode of the target battery as prediction data; and
an output layer (740, 830) configured to output the prediction data.

12. The battery degradation mode prediction system (10) according to claim 11, wherein the intermediate layer (820) comprises at least one of:
a first intermediate layer (822) configured to extract a feature related to the voltage profile data (120, 610);
a second intermediate layer (824) configured to process continuous time-series characteristics of the voltage profile data(120, 610);
a third intermediate layer (826) configured to select information based on a weight associated with a correlation between the voltage profile data (120, 610) and the profile data for each degradation mode (620); or
a fourth intermediate layer (828) configured to transform a data dimension based on information about a number of degradation modes.

13. The battery degradation mode prediction system (10) according to claim 12, wherein the second intermediate layer (824) is configured to obtain an output of the first intermediate layer (822) as an input to the second intermediate layer (824).

14. A battery degradation mode prediction method comprising:
generating (S1110) learning data (420) including a voltage profile data set (422) for a plurality of reference batteries and a profile data set (424) for each degradation mode of the plurality of reference batteries;
generating (S1120), based on the learning data (420), a prediction model (510) trained to receive the voltage profile data set (422) as an input and output the profile data set (424) for each degradation mode corresponding to the voltage profile data set (422);
obtaining (S1130) voltage profile data (120, 610) for a target battery;
obtaining (S1140), from the voltage profile data (120, 610) by using the prediction model (510), profile data (620) for each degradation mode of the target battery; and
outputting (S1150) lifespan data (140, 630) related to a degradation degree of the target battery for each degradation mode based on the profile data (620) for each degradation mode;
wherein the profile data (620) for each degradation mode comprises cycle-by-cycle degradation trend information for at least one of a degradation parameter associated with an electrode plate of the target battery or a degradation parameter associated with a resistance of the target battery.

15. A computer-readable medium comprising instructions which, when executed by a computer, cause the computer to carry out the method of claim 14.
